# EUROPÄISCHE PATENTSCHRIFT

(11) **EP 0 418 753 B1**
(45) Veröffentlichungstag und Bekanntmachung des Hinweises auf die Patenterteilung: **07.12.1994**
(21) Anmeldenummer: 90117754.3
(22) Anmeldetag: 14.09.1990
(51) Int. Cl.: H03F 1/30

(54) **Offsetspannungsabgleichender Operationsverstärker**
Offset voltage compensated operational amplifier
Amplificateur opérationnel à tension d offset compensée

(30) Priorität: 20.09.1989 EP 89117361
(43) Veröffentlichungstag der Anmeldung: 27.03.1991
(73) Patentinhaber: Deutsche ITT Industries GmbH, 79108 Freiburg (DE)
(72) Erfinder: Theus, Ulrich, Dr.-Ing., D-7803 Gundelfingen (DE)

(56) Entgegenhaltungen:
- EP-A- 0 161 215
- GB-A- 2 100 087
- NEW ELECTRONICS.INCORPORATING ELECTRONICS TODAY. vol. 20, no. 11, 26 Mai 1987,LONDON GB Seiten 33 - 35; B.DANCE: "CHOPPER STABILISED OPERATIONAL AMPLIFIERS"
- IBM TECHNICAL DISCLOSURE BULLETIN. vol. 19, no. 9, Februar 1977, NEW YORK USSeiten 3584 - 3585; T.A.SCHWARZ: "OFFSET COMPENSATION CIRCUIT"
- IEEE INTERNATIONAL SOLID STATE CIRCUITS CONFERENCE. vol. 30, Februar 1987, NEWYORK US Seiten 44-45 Seiten 333 - 334; M.ARMSTRONG et.al.: "A CMOS PROGRAMMABLESELF-CALIBRATING 13b EIGHT-CHANNEL ANALOG INTERFACE PROCESSOR"

## Beschreibung

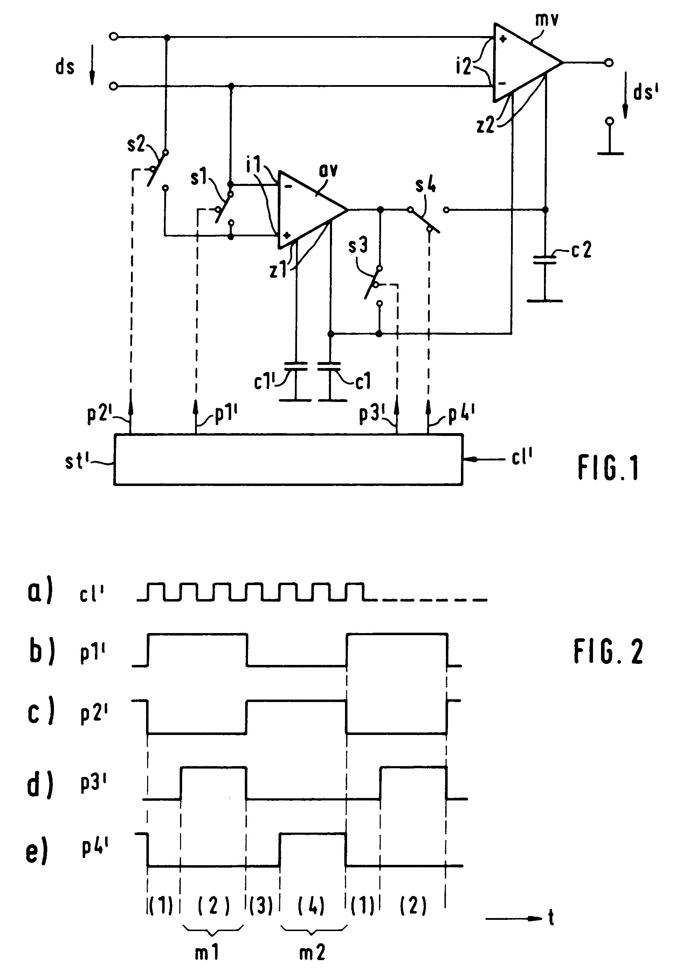

Bei der Verarbeitung von Gleichspannungsignalen oder Signalen mit einer niederen Frequenz tritt bei gleichspannungsgekoppelten Operationsverstärkern deren Eingang-Offsetspannung als Störgröße auf, insbesondere bei Operationsverstärkern in MOS-Technologie. Aus der Zeitschrift "Elektronik", Nr. 20, 30. September 1988, Seite 97 bis Seite 104 ist ein Verfahren bekannt, mit Hilfe eines Haupt- und eines Hilfsverstärkers, die jeweils einen von einer Offset-Kompensationsspannung gespeisten Auto-Zero-Eingang aufweisen, diese Offsetspannung während des Betriebes auszuregeln. Dabei wird während regelmäßiger Meßintervalle der Hilfsverstärker vom Eingangssignal getrennt und eingangsseitig kurzgeschlossen. Der sich dabei einstellende Ausgangspegel des Hilfsverstärkers wird mittels eines externen Kondensators gespeichert. Diese Kondensatorspannung wird dem Auto-Zero-Eingang des Hilfsverstärkers ununterbrochen als Hilfsverstärker-Offset-Kompensationsspannung zugeführt. Während des Betriebsintervalls wird der Hilfsverstärker eingangsseitig an das Eingangssignal und ausgangsseitig an einen zweiten externen Kondensator angeschlossen. Die mittels des zweiten Kondensators gespeicherte Spannung ist dem Auto-Zero-Eingang des Hauptverstärkers ununterbrochen als Hauptverstärker-Offset-Kompensationsspannung zugeführt. Durch die in den beiden externen Kondensatoren gespeicherten Potentiale wird im Betrieb der Einfluß der störenden Offsetspannung des gesamten Operationsverstärkers mittels der externen Rückkopplungsschaltung weitgehend ausgeregelt. Eine genauere Erläuterung der Funktionsweise ergibt sich aus der folgenden Beschreibung der Figuren 1 und 2.

Ein wesentlicher Nachteil des aus "Elektronik", Nr.20, 30. September 1988, Seiten 97 bis 104 bekannten offsetspannungsabgleichenden Operationsverstärkers ist die Verwendung von relativ großen Kondensatoren für die Speicherung der Offset-Kompensationsspannungen. Für eine monolithische Integration ist der erforderliche Flächenaufwand dieser Kondensatoren zu groß.

Aus "IEEE Solid-State/Circuits Conference", New York, Band 30, 25. Februar 1987, Seiten 44, 45, 333, 334 ist für ein A/D-Umsetzer ein selbstabgleichender CMOS-Abtastverstärker mit Hilfsverstärker bekannt. Zur Vermeidung der störenden Einflüsse von Ladungsinjektionen auf die Speicherkondensatoren während der verschiedenen Umschaltvorgänge wird die Empfindlichkeit des Hilfsverstärkers auf ein Zehntel des Hauptverstärkers reduziert. Die zu speichernden Spannungen sind daher zehnmal so groß, wodurch der störende Einfluß der gleichbleibenden Ladungsinjektion auf ein Zehntel reduziert wird. Der Haupt- und Hilfsverstärker sind in Form einer komplementären Kaskode (= folded cascode) zusammengeschaltet.

Auf ähnliche Weise wird in EP-A 1 61 215 bei einem selbstabgleichenden CMOS-Operationsverstärker der störende Einfluß der Ladungsinjektion auf die Offset-Kompensationsspannung vermindert. Der Eingang des Auto-Zero-Eingangs weist hierzu eine wesentlich geringere Empfindlichkeit als der differenzielle Signaleingang auf, wodurch die Spannung auf dem einzigen Speicherkondensator während des Meßintervalls einen entsprechend größeren Wert annimmt.

In GB-A 2 100 087 ist ebenfalls ein selbstabgleichender CMOS-Operationsverstärker beschrieben, bei dem eine kapazitive Signalrückführung vom Ausgang auf den Signaleingang vorgesehen ist, um Intermodulationsstörungen zu vermeiden. Diese können nämlich entstehen, wenn die Eingangswechselspannung von der Offsetfehler-Regelschaltung fälschlicherweise als momentaner Offsetfehler angesehen wird, der entsprechend auszuregeln ist. Durch diesen Regelvorgang wird auch das eigentliche Operationsverstärker-Ausgangssignal verfälscht.

Es ist daher Aufgabe der in den Ansprüchen gekennzeichneten Erfindung, eine Schaltungsanordnung für einen offsetspannungsabgleichenden Operationsverstärker anzugeben, dessen Speicherkondensatoren klein sind, so daß die gesamte Anordnung ohne zusätzliche Bauelemente monolithisch integrierbar ist.

Eine weitere Aufgabe der Erfindung ist es sicherzustellen, daß der Offsetspannungsabgleich nicht nur im stationären Betriebsbereich zufriedenstellend arbeitet, sondern auch dann, wenn sich die Eingangsspannung des Operationsverstärkers ändert und der Ausgang dieser Änderung proportional folgt, sofern die maximale Änderungsgeschwindigkeit nicht überschritten wird, z.B. bei einem Sprung.

Die Erfindung und weitere Ausgestaltungen und Vorteile werden nun anhand der Figuren der Zeichnung näher erläutert:
Fig. 1 zeigt schematisch das Blockschaltbild eines bekannten offsetspannungsabgleichenden Operationsverstärkers,
Fig. 2 zeigt hierzu die Zeitdiagramme der Steuersignale,
Fig. 3 zeigt schematisch das Blockschaltbild eines Operationsverstärkers nach der Erfindung,
Fig. 4 zeigt die Zeitdiagramme der zugehörigen Steuersignale und
Fig. 5a mit Fig. 5b zeigt als Schaltbild in CMOS-Technik ein weiteres Ausführungsbeispiel des Operationsverstärkers nach der Erfindung.

Bei der Schaltungsanordnung nach Fig. 1 bleibt der Hauptverstärker mv ständig mit dem eingangsseitigen Differenzsignal ds und mit dem Ausgang verbunden, so daß sich im Gegensatz zu üblichen Chopperverstärkern nur sehr geringe Schaltspitzen im Ausgangsssignal ds' ergeben. Der Offsetspannungsabgleich wird dadurch erreicht, daß ein interner Null-Verstärker - nämlich der Hilfsverstärker av - erst sich selbst und anschließend den Hauptverstärker mv zu Null abgleicht. Dem Selbstabgleich dienen vier elektronisch gesteuerte Schaltmittel s1, s2, s3, s4, ein externer erster und zweiter Speicherkondensator c1, c2, sowie ein zusätzlicher Hilfskondensator c1′. Die Funktionsweise in den verschiedenen Zeitbereichen (1) bis (4), vgl. Fig. 2, ergibt sich wie folgt:

Im Zeitbereich (1) wird der Hilfsverstärker av einseitig vom Differenzsignal ds getrennt und an seinem Differenzeingang i1 kurzgeschlossen. Das erste Schaltmittel s1 wird hierzu geschlossen und das zweite s2 geöffnet. Die Spannung am Ausgang des Hilfsverstärkers av ist daher allein durch den nicht kompensierten Rest seines Offsetspannungsfehlers bedingt. Im Zeitbereich (1) nimmt die Ausgangsspannung des Hilfsverstärkers av somit den Wert an, der sich als Produkt seiner Eingangsoffsetspannung und seiner Verstärkung ergibt, sofern die Ausgangsspannung innerhalb der Aussteuerungsgrenzen bleibt. Im Zeitbereich (1) kann der Ausgang des Hilfsverstärkers av auf den stabilen Ausgangswert einschwingen, der dem kurzgeschlossenen Eingang entspricht. Das dritte und das vierte Schaltmittel s3, s4 sind währenddessen im geöffneten Zustand.

Im Zeitbereich (2), der im folgenden auch als Meßintervall m1 bezeichnet wird, wird das dritte Schaltmittel s3 geschlossen und damit der externe erste Speicherkondensator c1 an den Ausgang des Hilfsverstärkers av angeschlossen. Das Potential dieses ersten Speicherkondensators c1 und des Hilfskondensators c1′ sind als Kompensationsspannungen dauernd einem differentiellen Auto-Zero-Eingang z1 des Hilfsverstärkers av zugeführt. Die Spannung, die sich am Ausgang des Hilfsverstärkers während dieses Zeitbereiches (2) einstellt, ist diejenige Hilfsverstärker-Offset-Kompensationsspannung, die erforderlich ist, um die Eingangsoffsetspannung des Hilfsverstärkers zu Null zu regeln. Die beiden Kondensatoren c1, c1′ müssen dabei das Potential über die zweite Hälfte des kompletten Abgleichzyklus hinweg festhalten. Das vierte Schaltmittel s4 bleibt währenddessen geöffnet.

Im Zeitbereich (3) werden die ersten und dritten Schaltmittel s1, s3 geöffnet und das zweite Schaltmittel s2 geschlossen. Dadurch wird der Differenzeingang i1 des Hilfsverstärkers an das Differenzsignal ds gelegt. Das vierte Schaltmittel s4 bleibt immer noch im geöffneten Zustand. In diesem Zeitbereich (3) ist das Ausgangssignal ds′ des Hauptverstärkers mv, dessen Differenzeingang i2 ohne Unterbrechung mit dem Differenzsignal ds gespeist ist, immer noch durch dessen Offsetspannung verfälscht. Im Zeitbereich (3) nimmt die Ausgangsspannung des Hilfsverstärkers av den Wert an, der sich als Produkt des nicht kompensierten Rests der Eingangsoffsetspannung des Hauptverstärkers mv und der Verstärkung des Hilfsverstärkers av gergibt, oder er geht in die entsprechende Übersteuerung.

Im Zeitbereich (4), der im folgenden auch als Betriebsintervall m2 bezeichnet wird, erfolgt schließlich die Kompensation des Hauptverstärkers mv. In diesem Betriebsintervall m2 findet der eigentliche Operationsverstärker-Betriebszustand der gesamten Schaltungsanordnung statt. Hierzu wird das vierte Schaltmittel s4 geschlossen, wodurch der zweite Speicherkondensator c2 an den Ausgang des Hilfsverstärkers av angeschlossen wird. Alle anderen Schaltmittel s1, s2, s3 behalten ihre vorherigen Schaltpositionen bei. Über jeweils eine Anschlußleitung sind die Potentiale des ersten und zweiten Speicherkondensators c1, c2 als Regelsignale auf den differentiellen Auto-Zero-Eingang z2 des Hauptverstärkers mv geführt, so daß dessen Offsetspannung ausgeregelt wird. Die eigentliche Regelung erfolgt dabei über die externe Rückkopplungsschaltung, wobei die Regelrichtung und die Regelbezugsgröße durch die vorgegebene Hauptverstärker-Offset-Kompensationsspannung vorgegeben ist. Die externe Rückkopplungsschaltung ist in Fig.1 nicht dargestellt, sie ergibt sich aus der jeweiligen Anwendungsschaltung des Operationsverstärkers.

Bei dieser Betrachtungsweise ist davon auszugehen, daß der Operationsverstärker eine sehr hohe Leerlaufverstärkung aufweist und daß die beiden Anschlußklemmen für das Differenzsignal ds nahezu auf gleichem Potential liegen. Dies entspricht der üblichen Betriebsweise von Operationsverstärkern, die in der Regel über die Peripherieschaltung mit einer starken Gleichspannungsgegenkopplung versehen sind.

Das Potential des zweiten Speicherkondensators c2 ist somit sowohl von der Offsetspannung des Hauptverstärkers mv als auch von der Offsetspannung des Hilfsverstärkers av abhängig. Indem man die Differenzspannung des ersten und zweiten Speicherkondensators c1, c2 dem Auto-Zero-Eingang z2 des Hauptverstärkers mv zuführt, wird dessen Offsetspannung bis auf einen kleinen Rest ausgeregelt.

Die Ansteuerung der Schaltmittel s1, ...., s4 erfolgt durch vier Steuersignale p1′,..., p4′, die aus einem Taktsignal cl′ in einer Steuerschaltung st′ gebildet werden. Dabei müssen die Steuersignale mindenstens zwei nichtüberlappende Zeitbereiche festlegen, nämlich das Meßintervall m1 und das Betriebsintervall m2 im Zeitbereich (2) bzw. (4), vgl. Fig. 2.

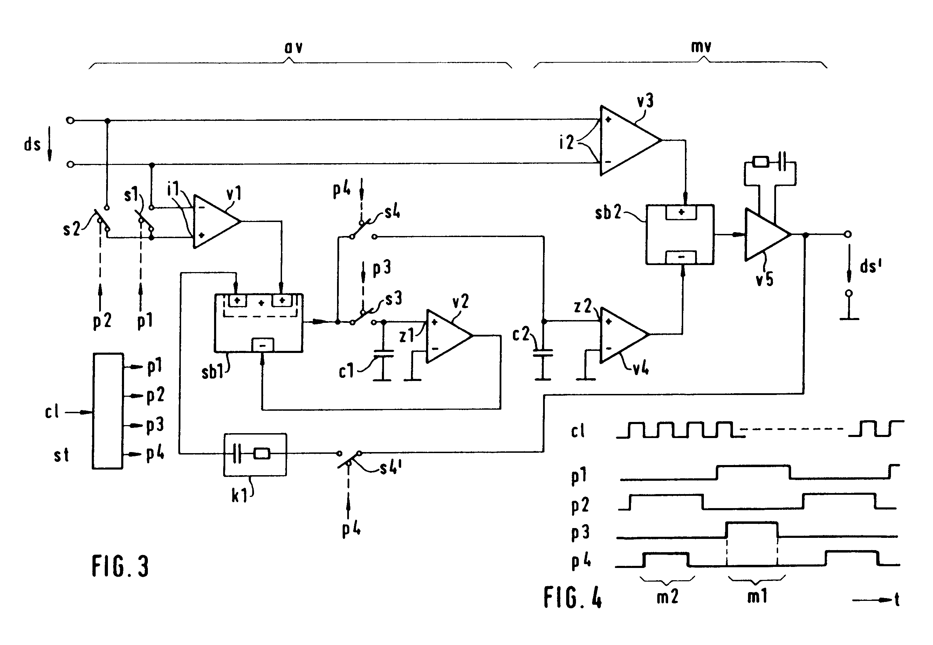

In Fig. 3 ist ein Ausführungsbeispiel eines offsetspannungsabgleichenden Operationsverstärkers nach der Erfindung dargestellt, wobei diejenigen Schaltungsteile, die funktionsgleich zu den entsprechenden Schaltungsteilen der Fig. 1 sind, mit gleichen Bezugszeichen versehen sind. Der Hilfverstärker av ist aus einem ersten und zweiten Verstärker v1, v2 und einer ersten Subtrahierschaltung sb1 gebildet. Die Realisierung der fünf Verstärker v1,...,v5 ist in Bipolar- oder in MOS-Technik möglich, wobei die Eingänge in der Regel spannungsgesteuert sind. Unabhängig davon können die Ausgänge als Strom- oder Spannungsquellen ausgebildet sein.

Der Hauptverstärker mv ist aus dem dritten, vierten und fünften Verstärker v3, v4, v5 und einer zweiten Subtrahierschaltung sb2 gebildet. Der erste Verstärker v1 weist eine erste vorgegebene Empfindlichkeit (= erster Empfindlichkeitswert) (= e1) auf. Die jeweilige Empfindlichkeit ist durch einen Steilheits- oder Verstärkungsfaktor definiert. Der erste Verstärker v1 bildet den Differenzeingang i1 des Hilfsverstärkers av. Der zweite Verstärker v2 weist eine zweite vorgegebene Empfindlichkeit (= zweiter Empfindlichkeitswert) (= e2) auf und bildet den Auto-Zero-Eingang z1. Der Ausgang des ersten bzw. zweiten Verstärkers v1, v2 ist mit dem Minuend- bzw. Subtrahend-Eingang der ersten Subtrahierschaltung sb1 verbunden, deren Ausgang als Hilfsverstärkerausgang dient.

Mit dem Ausgang der ersten Subtrahierschaltung sb1 ist über das dritte Schaltmittel s3 der erste Speicherkondensator c1 und der Eingang des zweiten Verstärkers v2 verbunden, wobei das dritte Schaltmittel s3 durch das dritte Steuersignal p3 geschaltet ist. Da der Empfindlichkeitswert e2 des zweiten Verstärkers mindestens um den Faktor 5, vorzugsweise jedoch um den Faktor 100 bis 200 gegenüber dem Empfindlichkeitswert e1 des ersten Verstärkers reduziert ist, stellt sich im Meßintervall m1 am ersten Speicherkondensator c1 ein Spannungswert ein, der um diesen unterschiedlichen Empfindlichkeitsfaktor größer ist als die auf den Ausgang bezogene Eingangsoffsetspannung des Verstärkers v1. Der Zweck eines möglichst großen Empfindlichkeitsverhältnisses e1/e2 ist es, die regelungsbedingten Änderungen der im ersten Kondensator c1 gespeicherten Spannung groß gegenüber dem Offsetspannungsfehler und anderen Fehlergrößen zu machen. Eine Fehlergröße ist die der gespeicherten Spannung überlagerte Störspannung, die beim Betrieb des dritten Schaltmittels s3 infolge von Ladungsinjektion entsteht. Eine weitere Fehlergröße ist der Spannungsverlust des Kondensators durch Leckströme innerhalb der Diffussionszonen. Da sich Fehler der Kondensatorspannung nur im Verhältnis e2/e1 auf die Eingangsoffsetspannung des Hilfsverstärkers auswirken, kann für eine im Toleranzbereich liegende Offsetspannung ein größerer Fehler der Kondensatorspannung zugelassen werden. Der wesentliche Vorteil dieser erfindungsgemäßen Maßnahme liegt jedoch darin, daß dadurch der erforderliche Kapazitätswert des ersten Speicherkondensators c1 sehr klein gewählt werden kann, z.B. 10 bis 60 Picofarad, ein Wert, der monolithisch ohne allzugroßen Flächenaufwand zu realisieren ist.

Am Ausgang der ersten Subtrahierschaltung sb1 ist das vom vierten Steuersignal p4 gesteuerte vierte Schaltmittel s4 angeschlossen, dessen Schalterausgang auf den zweiten Speicherkondensator c2 und den Eingang des vierten Verstärkers v4 geführt ist. Da der vierte Empfindlichkeitswert e4 gleich groß wie der zweite Empfindlichkeitswert e2 ist, und der dritte Empfindlichkeitswert e3 gleich groß wie der erste Empfindlichkeitswert e1 ist, stellt sich im Betriebsintervall m2 am zweiten Speicherkondensator c2 ein Potential ein, das um das Empfindlichkeitsverhältnis e3/e4 größer ist, als es bei gleichen Empfindlichkeitswerten wäre. Der wesentliche Vorteil entsprechend der Erfindung ist indessen auch hier wieder, daß der zweite Speicherkondensator c2 dadurch auf einen Wert von 10 Picofarad bis 60 Picofarad verkleinert werden kann und damit leicht monolithisch integrierbar ist.

Der Ausgang der zweiten Subtrahierschaltung sb2 speist den Eingang des fünften Verstärkers v5, der über seinen niederohmigen Ausgang und seine in der Regel hohe Leerlaufverstärkung das eigentliche Ausgangssignal des gesamten Operationsverstärkers liefert. Um die volle Gegenkopplungsfähigkeit des gesamten Operationsverstärkers zu ermöglichen, enthält der fünfte Verstärker v5 die übliche Frequenzkompensation mit einem Frequenzgang (= rolling off) von 20 db pro Dekade (= pole splitting frequency compensation), die in Fig. 3 durch das angeschlossene RC-Glied angedeutet ist. Ein separater Schaltungsblock stellt ferner die Steuereinrichtung st dar, die vom Taktsignal cl gesteuert, die vier Steuersignale p1, p2, p3, p4 für die vier Schaltmittel s1, s2, s3, s4 liefert.

Ist die Änderungsgeschwindigkeit und damit die Frequenz des Differenzsignals ds sehr klein gegenüber der Frequenz des vollständigen Meßzyklus, die beispielsweise 1 kHz beträgt, dann bewirkt die beschriebene Regelschaltung, daß der verbleibende Offsetfehler sehr klein wird.

Anders ist das Verhalten, wenn während des Betriebsintervalls m2 das Ausgangssignal ds′ des fünften Verstärkers v5 seinen Wert ändert. Dies tritt beispielsweise dann ein, wenn am Ausgang des fünften Verstärkers v5 ein Rampensignal zu bilden ist, dem infolge der endlichen Verstärkung und der internen Frequenzkompensation ein kleines Differenzsignal ds am Verstärkereingang entspricht. Diese Spannungsdifferenz am Eingang muß solange aufrechterhalten werden, wie der Ausgang des fünften Verstärkers v5 die Rampenspannung erzeugen soll. Während dieser Zeit versucht nun die Offset-Fehlerabgleichschaltung jeweils im Betriebsintervall m2 diesen Spannungsdifferenzwert als vermeintliche Offsetfehlerspannung auszuregeln und verfälscht daher das Ausgangssignal ds′ des fünften Verstärkers v5. Wegen der internen Frequenzgangkompensation ist der vermeintliche Offsetfehler frequenzabhängig - er ist um so größer, je höher die Frequenz des eingangsseitigen Differenzsignals ds ist.

Abhilfe schafft hier eine Signalrückführung über eine Kompensationsschaltung k1 vom Ausgang des fünften Verstärkers v5 auf einen Kompensationseingang der ersten Subtrahierschaltung sb1. Der Kompensationseingang ist dabei beispielsweise ein weiterer Minuend-Eingang mit einem Addierer, in dem die beiden Minuendsignale addiert werden und sich dabei bezüglich der höheren Frequenzanteile kompensieren, so daß der vermeintliche Offsetfehler zu Null wird. Da der Fehler im Betriebsintervall m2 auftritt, ist die Rückführung mittels eines weiteren vierten Schaltmittels s4′, das vom vierten Steuersignal p4 gesteuert ist, lediglich im Betriebsintervall m2 wirksam geschaltet. Die Kompensationsschaltung k1 weist einen Frequenzgang auf, der invers zu dem des fünften Verstärkers v5 ist. Damit ist sichergestellt, daß die Kompensation über den vollen Bereich der Frequenzkompensation des Operationsverstärkers zufriedenstellend funktioniert.

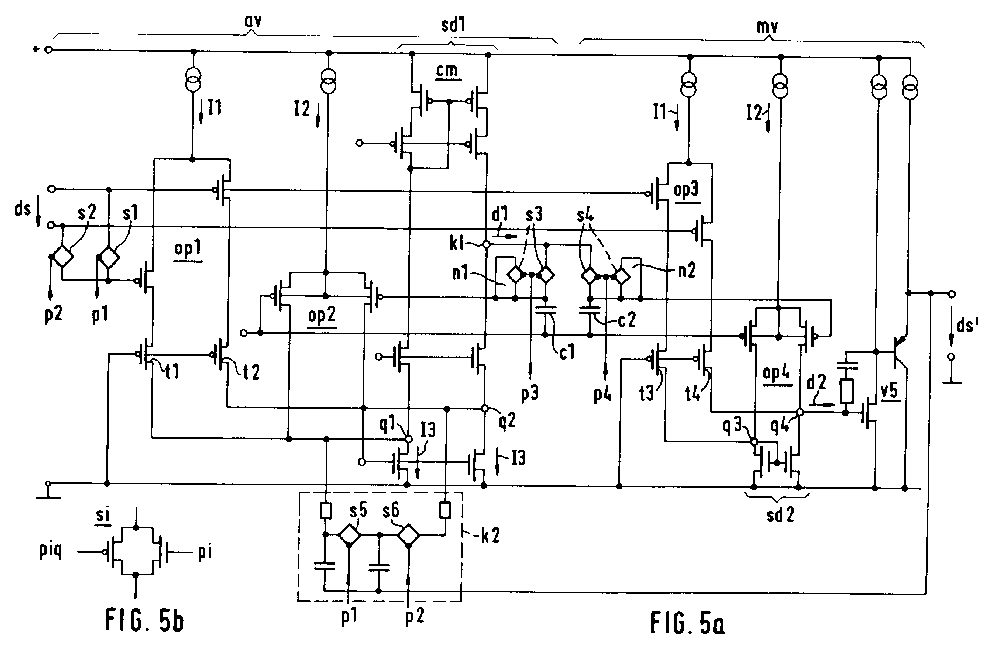

Fig. 5a zeigt in CMOS-Technik das Schaltbild eines weiteren Ausführungsbeispieles des offsetspannungsabgleichenden Operationsverstärkers. Der erste, zweite, dritte und vierte Verstärker v1,..., v4 ist dabei als erster, zweiter, dritter und vierter Transkonduktanz-Operationsverstärker (=OTA) op1, op2, op3, op4 ausgeführt. Die Differenzausgänge des ersten und zweiten OTA op1, op2 sind zur Stromdifferenzbildung auf einen ersten und einen zweiten Einkoppelpunkt q1, q2 einer ersten Stromdifferenzstufe sd1 geführt, die als erste Subtrahierschaltung sb1 dient.

Die Wirkungsweise der ersten Stromdifferenzstufe sd1, die eine kaskodierte Stromspiegelschaltung cm enthält, ist dabei wie folgt: der Ein- und der Ausgang der Stromspiegelschaltung cm sind über den ersten und zweiten Einkoppelpunkt q1, q2 jeweils mit einem gleichen Konstantstrom I3 gespeist. Zwischen dem zweiten Einkoppelppunkt q2 und dem Ausgang der Stromspiegelschaltung cm befindet sich der Auskoppelpunkt k1, an dem ein unipolarer erster Differenzstrom d1 als Ausgangssignal der Stromdifferenzstufe sd1 abgreifbar ist. Wenn den beiden Einkoppelpunkten q1, q2 außer den Konstantströmen I3 keine ungleichen weitere Ströme zugeführt werden, dann ist der Ausgangsstrom der Stromspiegelschaltung cm genau gleich groß wie der über den zweiten Einkoppelpunkt q2 zugeführte Strom. Der Differenzstrom d1 hat in diesem Fall den Wert Null. Wenn den beiden Einkoppelpunkten q1, q2 jedoch unterschiedliche Ströme zugeführt werden, dann wird ihre Stromdifferenz am Auskoppelpunkt k1 unipolar als erster Differenzstrom d1 abgeführt. Die Vorspannungserzeugung für die Kaskodetransistoren ist der Übersichtlichkeit wegen nicht dargestellt.

Im Hauptverstärker mv ist der Differenzausgang des dritten und vierten OTA op3, op4 zur Stromdifferenzbildung auf einen dritten und einen vierten Einkoppelpunkt q3, q4 einer zweiten Stromdifferenzstufe sd2 geschaltet, die als zweite Subtrahierschaltung sb2 dient und als Ausgangssignal einen zweiten Differenzstrom d2 erzeugt. Als Ausgangsklemme dient hierbei der vierte Einkoppelpunkt q4. Mit dem zweiten Differenzstrom d2 ist der fünfte Verstärker v5 angesteuert, der das Ausgangssignal ds′ liefert. Alle vier OTA enthalten in ihrem Eingang einen p-Kanal-Differenzverstärker, wobei in die Ausgangsleitungen des ersten und dritten OTA op1, op3 jeweils ein weiterer p-Kanal-Transistor t1, t2; t3, t4 in Kaskodeschaltung eingefügt ist. Die zweite Stromdifferenzstufe sd2 enthält eine einfache Stromspiegelschaltung aus zwei n-Kanal-Transistoren, wobei der Eingang der Stromspiegelschaltung mit dem dritten Einkoppelpunkt q3 und der Ausgang mit dem vierten Einkoppelpunkt q4 verbunden ist.

Die kleineren Empfindlichkeitswerte e2, e4 beim zweiten und vierten OTA op2, op4 werden dadurch erreicht, daß die Kanallänge des eingangsseitigen p-Kanal-Transistorpaares größer als beim ersten und dritten OTA op1, op3 ist. Ferner ist der Strom I2, mit dem der gemeinsame Source-Anschluß des eingangsseitigen p-Kanal-Transistorpaares beim zweiten bzw. vierten OTA op2, op4 angesteuert wird, etwa um eine Größenordnung kleiner als der Strom I1, mit dem der gemeinsame Source-Anschluß des ersten bzw. dritten OTA op1, op3 gespeist ist. Schließlich wird beim zweiten und vierten OTA op2, op4 der Empfindlichkeitswert e2, e4 dadurch verkleinert, daß die effektive Gate-Source-Spannung des eingangsseitigen p-Kanal-Transistorpaares erhöht wird; dazu ist es vorteilhaft das Wannengebiet dieser p-Kanal-Transistoren mit ihrem eigenen Sourceanschluß zu verbinden.

Die verwendeten Schaltmittel s1,..., s6; si (Fig. 5a und Fig. 5b) sind in der CMOS-Ausführung nach Fig. 5a jeweils als Transmission-Gate mit gegenphasigen Steuersignalen pi, piq ausgebildet. Die kapazitive Einkopplung des dritten bzw. vierten Steuersignals p3, p4 auf den ersten bzw. zweiten Speicherkondensator c1, c2 wird durch eine erste bzw. zweite Nachbildungsschaltung n1, n2 kompensiert. Die jeweilige Nachbildungsschaltung n1, n2 besteht dabei darin, daß auf der vom jeweiligen Speicherkondensator c1, c2 abgehenden Fühlerleitung ein kurzes Leitungsstück parallelgeschaltet ist (nur im elektrischen Sinn gemeint; eine geometrische Parallelität ist nicht erforderlich), das als wesentliches Element der Schalter-Nachbildung ein blindes drittes bzw. viertes Schaltmittel enthält, das an das dritte bzw. vierte Steuersignal p3, p4 angeschlossen ist. "Blind" bedeutet hier, daß lediglich die durch die Umschaltung bewirkten Transientenströme der Schalttransistoren des dritten und vierten Schaltmittels s3, s4, also reine kapazitive Ströme, auf der jeweiligen Fühlerleitung durch eine ähnliche aber entgegengesetzt wirkende Nachbildungsschaltung kompensiert werden sollen.

Die Kompensationsschaltung k2 in Fig. 5a enthält zwei Hochpaßfilterschaltungen, deren Frequenzgang invers zur 1/f-Gegenkopplung des fünften Verstärkers v5 ist und deren beide Ausgänge auf den ersten bzw. zweiten Einkoppelpunkt q1, q2 geschaltet sind. Dabei wird über das fünfte und sechste Schaltmittel s5, s6 erreicht, daß die Kompensationsschaltung k2 lediglich im Betriebsintervall m2 auf den ersten Differenzstrom d1 einwirkt.

Im Meßintervall m1 bewirkt die Regelschaltung im Hilfsverstärker av, daß sich die Spannung am ersten Speicherkondensator c1 durch den ersten Differenzstrom d1 solange ändert, bis der offsetfehlerbehaftete Ausgangsstrom des ersten OTA op1 durch eine entgegengesetzte Schieflage des zweiten OTA op2 ausgeglichen wird. In diesem Fall wird der erste Differenzstrom d1 zu Null und die Spannung am ersten Speicherkondensator c1 ändert sich nicht mehr. Der Regelkreis beim Hilfsverstärker av zeigt somit Integralverhalten. Die erforderliche Schieflage des zweiten OTA op2 bleibt im Betriebsintervall m2 durch die im ersten Speicherkondensator c1 festgehaltene Spannung gewährleistet.

Im Betriebsintervall m2 wird der offsetfehlerbehaftete Ausgangsstrom des dritten OTA op3 durch eine entsprechende Schieflage des vierten OTA op4 ausgeglichen. Die jeweilige Schieflage des vierten OTA op4 wird von der Spannung des zweiten Speicherkondensators c2 gesteuert. Dabei ändert sich über den ersten Differenzstrom d1 die Spannung am zweiten Speicherkondensator c2 solange, bis der Hilfsverstärker av an seinem Differenzeingang keine Spannungsdifferenz mehr feststellt. Es liegt also auch in diesem zweiten Regelkreis ein integrales Regelverhalten vor.

## Patentansprüche

1. Offsetspannungsabgleichender Operationsverstärker für Differenzsignale (ds) mit
- einem Hilfsverstärker (av), der einen Auto-Zero-Eingang (z1) und einen Differenzeingang (i1) aufweist, der mittels elektronischer erster und zweiter Schaltmittel (s1, s2) kurzschließbar und vom Differenzsignal (ds) zu trennen ist,
- einem Hauptverstärker (mv), der einen Differenzeingang (i2) und einen Auto-Zero-Eingang (z2) aufweist,
- einem ersten Speicherkondensator (c1), der zur Umladung über elektronische dritte Schaltmittel (s3) mit dem Ausgang des Hilfsverstärkers (av) gekoppelt ist und dessen Spannung dem Auto-Zero-Eingang (z1) des Hilfsverstärkers (av) zugeführt ist,
- einem zweiten Speicherkondensator (c2), der zur Umladung über elektronische vierte Schaltmittel (s4) mit dem Ausgang des Hilfsverstärkers (av) gekoppelt ist und dessen Spannung dem Auto-Zero-Eingang (z2) des Hauptverstärkers (mv) zugeführt ist, und mit
- einer Steuereinrichtung (st; st′), die Steuersignale (p1`,..., p4`; p1, ..., p4) für die vier Schaltmittel (s1, ..., s4) erzeugt, wobei die Steuersignale ein Meßintervall (m1), in dem der Hilfverstärker (av) eingangsseitig kurzgeschlossen ist, und ein nichtüberlappendes Betriebsintervall (m2), in dem der Hilfsverstärker (av) und der Hauptverstärker (mv) eingangsseitig mit dem Differenzsignal (ds) gespeist sind, festlegen,
gekennzeichnet durch folgende Merkmale:
- ein erster Verstärker (v1) mit erster vorgegebener Empfindlichkeit des Wertes e1 bildet den Differenzeingang (i1) des Hilfsverstärkers (av),
- ein zweiter Verstärker (v2) mit zweiter vorgegebener Empfindlichkeit des Wertes e2, bildet den Auto-Zero-Eingang (z1) des Hilfsverstärkers (av), wobei e2 kleiner als e1 ist,
- der Ausgang des ersten bzw. zweiten Verstärkers (v1, v2) ist mit dem Minuend- bzw. Subtrahend-Eingang einer ersten Subtrahierschaltung (sb1) verbunden, deren Ausgang als Hilfsverstärkerausgang dient,
- ein dritter Verstärker (v3) mit dritter vorgegebener Empfindlichkeit des Wertes e3 bildet den Differenzeingang (i2) des Hauptverstärkers (mv),
- ein vierter Verstärker (v4) mit vierter vorgegebener Empfindlichkeit des Wertes e4 bildet den Auto-Zero-Eingang (z2) des Hauptverstärkers (mv), wobei e4 kleiner als e3 ist, und
- der Ausgang des dritten bzw. vierten Verstärkers (v3, v4) ist mit dem Minuend- bzw. Subtrahend-Eingang einer zweiten Subtrahierschaltung (sb2) verbunden, an deren Ausgang ein fünfter Verstärker (v5) angeschlossen ist, dessen Ausgang als Hauptverstärkerausgang dient.

2. Operationsverstärker nach Anspruch 1, gekennzeichnet durch folgende Merkmale:
- an den Ausgang des fünften Verstärkers (v5) ist über ein weiteres viertes Schaltmittel (s4`) eine Kompensationsschaltung (k1) angeschlossen, deren Ausgang auf einen Kompensationseingang der ersten Subtrahierschaltung (sb1) geführt ist,
- die Kompensationsschaltung (k1) weist einen Frequenzgang auf, der invers zu dem des fünften Verstärkers (v5) ist und
- das weitere vierte Schaltmittel (s4`) stellt die Signalrückführung während des Betriebsintervalls (m2) her.

3. Operationsverstärker nach Anspruch 2, dadurch gekennzeichnet, daß er in MOS-Technik monolithisch integriert ist und daß der erste bzw. zweite bzw. dritte bzw. vierte Verstärker (v1,..,v4) ein erster bzw. ein zweiter bzw. ein dritter bzw. ein vierter Transkonduktanz-Operationsverstärker (=OTA) (op1, op2, op3, op4) ist.

4. Operationsverstärker nach Anspruch 3, gekennzeichnet durch folgende Merkmale:
- der jeweilige Empfindlichkeitswert e2 bzw. e4 des zweiten bzw. des vierten OTA (op2, op4) ist gegenüber dem jeweiligen Empfindlichkeitswert e1 bzw. e3 des ersten bzw. des dritten OTA (op1, op3) mindestens um den Faktor 5, vorzugsweise um ca. zwei Zehnerpotenzen, reduziert,
- der Empfindlichkeitswert e1 und e3 bzw. e2 und e4 des ersten und des dritten bzw. des zweiten und des vierten OTA (op1, op3; op2, op4) sind einander gleich und
- der erste und der zweite Speicherkondensator (c1, c2) sind monolithisch integriert.

5. Operationsverstärker nach Anspruch 4, gekennzeichnet durch folgende Merkmale:
- als erste Subtrahierschaltung (sb1) dient eine erste Stromdifferenzstufe (sd1) mit einem ersten und einem zweiten Einkoppelpunkt (q1, q2), an die die gegenphasigen Stromausgänge des ersten und des zweiten OTA (op1, op2) zur Differenzbildung angeschlossen sind,
- als zweite Subtrahierschaltung (sb2) dient eine zweite Stromdifferenzstufe (sd2) mit einem dritten und einem vierten Einkoppelpunkt (q3, q4), an die die gegenphasigen Stromausgänge des dritten und des vierten OTA (op3, op4) zur Differenzbildung angeschlossen sind, und
- eine Ausgangsklemme (k1, q4) der ersten bzw. zweiten Stromdifferenzstufe (sd1, sd2) liefert als unipolaren Ausgangsstrom einen ersten bzw. einen zweiten Differenzstrom (d1, d2).

6. Operationsverstärker nach Anspruch 5, gekennzeichnet durch folgende Merkmale:
- der fünfte Verstärker (v5) enthält eine 1/f-Gegenkopplung,
- die am Ausgang dieses fünften Verstärkers (v5) angeschlossene Kompensationsschaltung (k2), enthält zwei Hochpaßfilterschaltungen, deren Frequenzgang invers zur 1/f-Gegenkopplung des fünften Verstärkers v5 ist und deren beiden Ausgänge mit den beiden Einkoppelpunkten (q1, q2) der ersten Stromdifferenzstufe (sd1) gekoppelt sind, wobei fünfte und sechste Schaltmittel (s5, s6), die innerhalb der Kompensationsschaltung (k2) eingefügt und vom ersten bzw. zweiten Steuersignal (p1, p2) gesteuert sind, bewirken, daß die Kompensationsschaltung (k2) nur im Betriebsintervall (m2) auf den ersten Differenzstrom (d1) einwirkt.

7. Operationsverstärker nach Anspruch 4, dadurch gekennzeichnet, daß zwischen dem Fühleranschluß des ersten bzw. des zweiten Speicherkondensators (c1, c2) und dem Auto-Zero-Eingang (z1, z2) des Hilfs- bzw. Hauptverstärkers (av, mv) eine erste bzw. eine zweite Nachbildungsschaltung (n1, n2) mit einem blinden dritten bzw. einem blinden vierten Schaltmittel eingefügt ist, dem das dritte bzw. das vierte Steuersignal (p3, p4) zugeführt ist.

8. Operationsverstärker nach Anspruch 6 und 7, dadurch gekennzeichnet, daß er in CMOS-Technik monolithisch integriert ist und daß den sechs Schaltmitteln (s1,..., s6) und den blinden Schaltmitteln der beiden Nachbildungsschaltungen (n1, n2) jeweils gegenphasige Steuersignale (pi, piq) zugeführt sind.

9. Operationsverstärker nach Anspruch 4, dadurch gekennzeichnet, daß der Empfindlichkeitswert des jeweiligen OTA (op1,...,op4) über die Kanallänge und die effektive Gate-Source-Spannung der eingangsseitigen FET-Transistor-Differenzstufe und die Höhe des von der jeweiligen Konstantstromquelle gelieferten Stromes (I1, I2) eingestellt ist.

10. Operationsverstärker nach Anspruch 5, gekennzeichnet durch folgende Merkmale:
- der erste bzw. der dritte OTA (op1, op3) enthält in seinem Differenzausgang in Kaskodeschaltung einen ersten und einen zweiten bzw. einen dritten und einen vierten FET-Transistor (t1, t2; t3, t4) und
- die erste Stromdifferenzstufe (sd1) enthält eine Stromspiegelschaltung (cm) in Kaskodeschaltung.

## Claims

1. Offset-voltage-balancing operational amplifier for difference signals (ds), comprising
- an auxiliary amplifier (av) having an auto-zero input (z1) and a differential input (i1) which can be short-circuited by means of electronic first and second switching means (s1, s2) and is to be separated from the difference signal (ds),
- a main amplifier (mv) having a differential input (i2) and an auto-zero input (z2),
- a first storage capacitor (c1) which is coupled via electronic third switching means (s3) to the output of the auxiliary amplifier (av) for reversing its charge, and whose voltage is applied to the auto-zero input (z1) of the auxiliary amplifier (av),
- a second storage capacitor (c2) which is coupled via electronic fourth switching means (s4) to the output of the auxiliary amplifier (av) for reversing its charge, and whose voltage is applied to the auto-zero input (z2) of the main amplifier (mv), and
- a controller (st; st′) which provides the control signals (p1′, ... p4′; p1, ..., p4) for the four switching means (s1, ..., s4), said control signals defining a measurement interval (m1), in which the auxiliary amplifier (av) is short-circuited at the input end, and a nonoverlapping operating interval (m2), in which the auxiliary amplifier (av) and the main amplifier (mv) are fed with the difference signal (ds),
characterized by the following features:
- A first amplifier (v1) having a first predetermined sensitivity of value e1 forms the difference input (i1) of the auxiliary amplifier (av);
- a second amplifier (v2) having a second predetermined sensitivity of value e2 forms the auto-zero input (z1) of the auxiliary amplifier (av), with e2 being less than e1;
- the outputs of the first and second amplifiers (v1, v2) are connected to the minuend and subtrahend inputs, respectively, of a first subtracter (sb1),whose output serves as the auxiliary-amplifier output;
- a third amplifier (v3) having a third predetermined sensitivity of value e3 forms the difference input (i2) of the main amplifier (mv);
- a fourth amplifier (v4) having a fourth predetermined sensitivity of value e4 forms the auto-zero input (z2) of the main amplifier (mv), with e4 being less than e3, and
- the outputs of the third and fourth amplifiers (v3, v4) are connected to the minuend and subtrahend inputs, respectively, of a second subtracter (sb2) having its output coupled to a fifth amplifier (v5) whose output serves as the main-amplifier output.

2. An operational amplifier as claimed in claim 1, characterized by the following features:
- The output of the fifth amplifier (v5) is connected via an additional fourth switching means (s4′) to a compensation circuit (k1) having its output coupled to a compensation input of the first subtracter (sb1);
- the compensation circuit (k1) has a frequency response which is inverse to that of the fifth amplifier (v5), and
- the additional fourth switching means (s4′) completes a feedback path during the operating interval (m2).

3. An operational amplifier as claimed in claim 2, characterized in that it is integrated using MOS technology, and that the first, second, third, and fourth amplifiers (v1, ..., v4) are first, second, third, and fourth operational transconductance amplifiers (= OTAs) (op1, op2, op3, op4), respectively.

4. An operational amplifier as claimed in claim 3, characterized by the following features:
- The respective sensitivity values e2 and e4 of the second and fourth OTAs (op2, op4) are less than the respective sensitivity values e1 and e3 of the first and third OTAs (op1, op2) by at least a factor of 5, preferably by about the second power of ten;
- the sensitivity values e1 and e3 of the first and third OTAs (op1, op3) and the sensitivity values e2 and e4 of the second and fourth OTAs (op2, op4) are equal, and
- the first and second storage capacitors (c1, c2) are realized using monolithic integrated circuit techniques.

5. An operational amplifier as claimed in claim 4, characterized by the following features:
- The first subtracter (sb1) is a first current-difference stage (sd1) having first and second feed-in points (q1, q2) to which the antiphase current outputs of the first and second OTAs (op1, op2) are connected;
- the second subtracter (sb2) is a second current-difference stage (sd2) having third and fourth feed-in points (q3, q4) to which the antiphase current outputs of the third and fourth OTAs (op3, op4) are connected, and
- an output terminal (kl) of the first current-difference stage (sd1) and an output terminal (q4) of the second current-difference stage (sd2) deliver a first difference current (d1) and a second difference current (d2), respectively, as unipolar output currents.

6. An operational amplifier as claimed in claim 5, characterized by the following features:
- The fifth amplifier (v5) uses 1/f negative feedback;
- the compensation circuit (k2) connected to the output of the fifth amplifier (v5) contains two high-pass filters whose frequency response is inverse to the 1/f negative feedback applied around the fifth amplifier (v5) and whose two outputs are coupled to the two feed-in points (q1, q2) of the first current-difference stage (sd1), with the fifth and sixth switching means (s5, s6), which are incorporated in the compensation circuit (k2) and controlled by the first and second control signals (p1, p2), respectively, causing said compensation circuit (k2) to act on the first difference current (d1) only in the operating interval (m2).

7. An operational amplifier as claimed in claim 4, characterized in that a first simulating circuit (n1) comprising a reactive third switching means fed with the third control signal (p3) is inserted between the sense terminal of the first storage capacitor (c1) and the auto-zero input (z1) of the auxiliary amplifier (av), and a second simulating circuit (n2) comprising a reactive fourth switching means fed with the fourth control signal (p4) is inserted between the sense terminal of the second storage capacitor (c2) and the auto-zero input (z2) of the main amplifier (mv).

8. An operational amplifier as claimed in claims 6 and 7, characterized in that it is implemented using CMOS technology, and that antiphase control signals (pi, piq) are applied to each of the six switching means (s1, ..., s6) and to each of the reactive switching means of the two simulating circuits (n1, n2).

9. An operational amplifier as claimed in claim 4, characterized in that the sensitivity value of the respective OTA (op1, ..., op4) is adjusted via the channel length and the effective gate-to-source voltage of the field-effect transistor difference stage at the input end and via the value of the current (I1, 12) delivered by the respective constant-current source.

10. An operational amplifier as claimed in claim 5, characterized by the following features:
- The first OTA (op1) includes in its output stage a first field-effect transistor (t1) and a second field-effect transistor (t2) in a cascode configuration, and the third OTA (op3) includes in its output stage a third field-effect transistor (t3) and a fourth field-effect transistor (t4) in a cascode configuration, and
- the first current-difference stage (sd1) comprises a current mirror (cm) in a cascode configuration.

## Revendications

1. Amplificateur opérationnel à tension de décalage compensée pour les signaux de différence (ds), comportant
- un amplificateur auxiliaire (av), qui possède une entrée de zéro automatique (z) et une entrée de différence (i1) et qui doit pouvoir être court-circuitée par l'intermédiaire de premiers et seconds moyens de commutation électroniques (s1, s2) et doit être séparé du signal de différence (ds),
- un amplificateur principal (mv), qui possède une entrée de différence (i2) et une entrée de zéro automatique (z2),
- un premier condensateur de stockage (c1), qui est couplé à la sortie de l'amplificateur auxiliaire (av) pour réaliser la décharge par l'intermédiaire de troisièmes moyens de commutation électroniques (s3) et dont la sortie est raccordée à l'entrée de zéro automatique (z1) de l'amplificateur auxiliaire (av),
- un second condensateur de stockage (c2), qui est couplé à la sortie de l'amplificateur auxiliaire (av) pour la décharge par l'intermédiaire de quatrièmes moyens de commutation électronique (s4) et dont la tension est envoyée à l'entrée de zéro automatique (z2) de l'amplificateur principal (mv), et comportant
- un dispositif de commande (st; st′), qui produit des signaux de commande (p1′, ... p4′; p1, ..., p4) pour les quatre moyens de commutation (s1, ..., s4), les signaux de commande fixant un intervalle de mesure (m1), pendant lequel l'amplificateur auxiliaire (av) est court-circuité côté entrée, et un intervalle de fonctionnement sans chevauchement (m2), dans lequel l'amplificateur auxiliaire (av) et l'amplificateur principal (mv) sont alimentés côté entrée par le signal de différence (ds),
caractérisé par les caractéristiques suivantes :
- un premier amplificateur (v1) possédant une première sensibilité prédéterminée de valeur e1 forme l'entrée de différence (i1) de l'amplificateur auxiliaire (av),
- un second amplificateur (v2) possédant une seconde sensibilité prédéterminée de valeur e2 forme l'entrée de zéro automatique (z1) de l'amplificateur auxiliaire (av), e2 étant inférieure à e1,
- la sortie du premier ou du second amplificateur (v1, v2) est raccordée à l'entrée du diminuende ou à l'entrée du nombre à soustraire d'un premier circuit soustracteur (sb1) dont la sortie est utilisée comme sortie de l'amplificateur auxiliaire,
- un troisième amplificateur (v3) possédant une troisième sensibilité prédéterminée de valeur e3 forme l'entrée de différence (i2) de l'amplificateur principal (mv),
- un quatrième amplificateur (v4) possédant une quatrième sensibilité prédéterminée de valeur (e4) forme l'entrée de zéro automatique (z2) de l'amplificateur principal (mv), e4 étant inférieure à e3, et
- la sortie du troisième ou du quatrième amplificateur (v3, v4) est reliée à l'entrée du diminuende ou à l'entrée du nombre à soustraire d'un second circuit soustracteur (sb2), à la sortie duquel est raccordé un cinquième amplificateur (v5), dont la sortie est utilisée en tant que sortie de l'amplificateur principal.

2. Amplificateur opérationnel selon la revendication 1, caractérisé par les caractéristiques suivantes :
- à la sortie du cinquième amplificateur (v5) est raccordé, par l'intermédiaire de quatrièmes autres moyens de commutation (s4′), un circuit de compensation (k1), dont la sortie est raccordée à une entrée de compensation du premier circuit soustracteur (sb1),
- le circuit de compensation (k1) possède une réponse en fréquence, qui est inverse de celle du cinquième amplificateur (v5), et
- les autres quatrièmes moyens de commutation (s4′) réalisent le renvoi du signal pendant l'intervalle de fonctionnement (m2).

3. Amplificateur opérationnel selon la revendication 2, caractérisé en ce qu'il est intégré sous forme analytique selon la technique MOS et que le premier, le second ou le troisième ou le quatrième amplificateur (v1, ..., v4) est un premier ou un second ou un troisième ou un quatrième amplificateur opérationnel à transconductance (=OTA) (op1, op2, op3, op4).

4. Amplificateur opérationnel selon la revendication 3, caractérisé par les caractéristiques suivantes :
- la valeur respective de sensibilité e2 ou e4 du second ou du quatrième amplificateur OT1 (op2, op4) est réduite, par rapport à la valeur respective de sensibilité e1 ou e3 du premier ou du troisième amplificateur OTA (op1, op3), au moins dans le rapport 5 et de préférence environ de deux puissances de 10,
- les valeurs de sensibilité e1 et e3 ou e2 et e4 des premier et troisième amplificateurs ou des second et quatrième amplificateurs OTA (op1, op3; op2, op4) sont égales, et
- les premier et second condensateurs de stockage (c1, c2) sont intégrés de façon monolithique.

5. Amplificateur opérationnel selon la revendication 4, caractérisé par les caractéristiques suivantes :
- en tant que premier circuit soustracteur (sb1), on utilise un premier étage de formation de différence de courant (sd1) comportant des premier et second points d'injection (q1, q2), auxquels sont raccordées les sorties de courant en opposition de phase des premier et second amplificateurs OTA (op1, op2) pour la formation de la différence,
- en tant que second circuit soustracteur (sp2) on utilise un second étage de formation de différence de courant (sp2) comportant des troisième et quatrième points d'injection (q3, q4), auxquels sont raccordés les sorties de courant en opposition de phase des troisième et quatrième amplificateurs OTA (op3, op4) pour la formation de la différence, et
- une borne de sortie (k1, q4) du premier ou du second étage de formation de différence de courant (sd1, sd2) délivre, sous la forme d'un courant de sortie unipolaire, un premier ou un second courant différentiel (d1, d2).

6. Amplificateur opérationnel selon la revendication 5, caractérisé par les caractéristiques suivantes :
- le cinquième amplificateur (v5) contient un système de contre-réaction 1/f,
- le circuit de compensation (k2), qui est raccordé à la sortie de ce cinquième amplificateur (v5), contient deux circuits formant filtres passe-haut, dont la réponse en fréquence est inverse de la contre-réaction 1/f du cinquième amplificateur (v5) et dont les deux sorties sont couplées aux deux points d'injection (q1, q2) du premier étage de formation de différence de courant (sd1), des cinquième et sixième moyens de commutation (s5, s6), qui sont insérés dans le circuit de compensation (k2) et sont commandés par le premier ou le second signal de commande (p1, p2) agissent de telle sorte que le circuit de compensation (k2) agit sur le premier courant différentiel (d1) uniquement pendant l'intervalle de temps (m2).

7. Amplificateur opérationnel selon la revendication 4, caractérisé en ce qu'entre la borne de détection du premier ou du second condensateur de stockage (c1, c2) une entrée de zéro automatique (z1, z2) de l'amplificateur auxiliaire ou de l'amplificateur principal (av, mv) est insérée à un premier ou à un second circuit d'équilibrage (n1, n2) comportant des troisièmes ou des quatrièmes moyens de commutation aveugles, auxquels est envoyé le troisième ou le quatrième signal de commande (p3, p4).

8. Amplificateur opérationnel selon les revendications 6 et 7, caractérisé en ce qu'il est intégré de façon monolithique selon la technique CMOS et que des signaux de commande (pi, piq) réciproquement en opposition de phase sont envoyés aux six moyens de commutation (s1, ... , s6) et aux moyens de commutation aveugles des deux circuits d'équilibrage (n1, n2).

9. Amplificateur opérationnel selon la revendication 4, caractérisé en ce que la valeur de sensibilité de l'amplificateur respectif OTA (op1, ..., op4) est réglée par l'intermédiaire de la longueur de canal et de la tension effective grille-source de l'étage de formation de différence à transistors FET, situé côté entrée, et par l'intensité du courant (I1, I2) délivré par la source de courant constant respective.

10. Amplificateur opérationnel selon la revendication 5, caractérisé par les caractéristiques suivantes :
- le premier ou le troisième amplificateur OTA (op1, op3) contient dans sa sortie de différence, selon un montage cascode, des premier et second transistors FET et des troisième et quatrième transistors FET (t1, t2; t3, t4) et
- le premier étage de formation de différence de courant (sd1) contient un circuit formant miroir de courant (cm) monté selon un montage cascode.
